# EUROPEAN PATENT SPECIFICATION

(11) **EP 1 184 489 B1**
(45) Date of publication and mention of the grant of the patent: **12.12.2012**
(21) Application number: 01121026.7
(22) Date of filing: 31.08.2001
(51) Int. Cl.: C30B 25/14, C30B 29/40, H01L 21/205

(54) **Impurity doping method for semiconductor as well as system therefor and semiconductor materials prepared thereby**
Verfahren und Vorrichtung zur Dotierung eines Halbleiters und dadurch hergestelltes Halbleitermaterial
Procédé et appareillage pour le dopage des sémiconducteurs et matériaux sémiconducteurs ainsi obtenus

(30) Priority: 01.09.2000 JP 2000264743
(43) Date of publication of application: 06.03.2002
(73) Proprietor: RIKEN, Wako-shi, Saitama 351-0198 (JP)
(72) Inventor: Aoyagi, Yoshinobu,, Wako-shi, Saitama 351-0198 (JP); Iwai, Souhachi,, Wako-shi, Saitama 351-0198 (JP); Hirayama, Hideki,, Wako-shi, Saitama 351-0198 (JP)
(74) Representative: Grünecker, Kinkeldey, Stockmair & Schwanhäusser

(56) References cited:
- EP-A- 0 439 064
- US-A- 5 082 798
- US-A- 5 338 389
- US-A- 5 693 139
- OHUCHI Y ET AL: "New dopant precursors for n-type and p-type GaN" JOURNAL OF CRYSTAL GROWTH, NORTH-HOLLAND PUBLISHING CO. AMSTERDAM, NL, vol. 170, no. 1-4, 1997, pages 325-328, XP004087127 ISSN: 0022-0248

## Description

### Background of the Invention

### Field of The Invention

The present invention relates to an impurity doping method for semiconductor as well as to a system therefor and semiconductor materials prepared thereby, and more particularly to an impurity doping method for semiconductor used suitably in case of preparing a semiconductor material having a high conductance as well as a system therefor and semiconductor materials each having a high conductance prepared thereby.

### Description of The Related Art

Heretofore, there has been known an impurity doping method for semiconductor wherein plural types of crystal raw materials and plural types of impurity raw materials are used in a predetermined crystal growth device or the like in case of preparing a semiconductor material, and both of the crystal raw materials and the impurity rawmaterials are continuously supplied, whereby a crystal layer formed on a substrate from the crystal raw materials is doped with the impurities.

Meanwhile, in such conventional impurity doping method for semiconductor as described above, since both these plural types of crystal raw materials and these plural types of impurity raw materials are continuously supplied, plural types of impurities are disorderly incorporated into an atomic layer of crystals to be formed on a substrate from the crystal raw materials.

For this reason, when these plural types of impurity raw materials involve p-type impurity raw materials and n-type impurity raw materials, respectively, the p-type impurity raw materials and the n-type impurity raw materials cancel with each other (compensation effect), so that a carrier concentration becomes a difference defined between concentrations of these p- and n-type impurity raw materials. Accordingly, there has been such a problem that a carrier concentration of a semiconductor material to be fabricated decreases, and it results in a low conductance.

Furthermore, when both of plural types of crystal raw materials and plural types of impurity raw materials are continuously supplied to prepare a p-type semiconductor material in accordance with a conventional impurity doping method for semiconductor, an impurity level in a forbidden gap of the p-type semiconductor material is deep; and the p-type semiconductor exhibits high activation energy. Accordingly, there has been also such a problem that positive hole having a high density cannot be obtained, and it results in a low conductance.

US 5,693,139 focused on the fact that a semiconductor becomes p-type or n-type by performing the doping of one kind of atom via the atomic layer growth of alternate supply. According to the method of D1, although the semiconductor of p-type or n-type is naturally created, only an acceptor level or a donor level of a deep level is created as usual in the semiconductor having a deep band gap like GaN and so forth, and the method is not useful for forming a highly concentrated p-type layer of a so-called wide-band semiconductor having a large band gap at all, beacause of deep acceptor and donor level.

US 5 338 389 discloses an impurity doping method having the steps of supplying subsequently a component gas made of TEG or TMG and AsH₃, wherein said supply of AsH₃ to the beginning of the supply of AsH₃ defines one cycle. Within said cycle, compound gases of dopant comprising a p-type doping impurity material gas or a n-type dopant gas is supplied either simultaneously with said gas of TEG or TMG or with said component gas of AsH3 or before or after said supply of said component gas of TEG or TMG. Furthermore, this prior art discloses a supply of a reaction gas composed of H2, which is supplied either simultaneously with said TEG or TMG, respectively, or with AsH3 or with said compound gases of dopant or before or after said compound gases of dopant.

### Object and Summary of The Invention

The present invention has been made in view of the above-described problems involved in the prior art, and an object of the invention is to provide an impurity doping method for semiconductor by which a carrier concentration is adapted to increase, whereby a semiconductor material having a high conductance can be prepared, even in the case when a crystal layer is doped with p-type impurity raw materials and n-type impurity raw materials as well as to provide a system for preparing such semiconductor materials.

Furthermore, another object of the present invention is to provide an impurity doping method for semiconductor and a system therefor by which a p-type semiconductor material with positive hole having a high density and exhibiting a high conductance can be prepared.

Moreover, a further object of the present invention is to provide a semiconductor material having a high conductance.

In order to achieve the above-described objects, an impurity doping method for semiconductor wherein a crystal layer made of crystal raw materials is doped with impurities according to the present invention comprises each of plural types of impurity raw materials being supplied at close timings in a pulsed manner within one cycle wherein all types of the crystal raw materials are supplied in one time each in the case when plural types of the crystal raw materials are alternately supplied in a pulsed manner with maintaining each of predetermined purge times.

Furthermore, an impurity doping method for semiconductor wherein a crystal layer made of crystal raw materials is doped with impuri ties according to the present invention comprises each of plural types of impurity raw materials being supplied at close timings in a pulsed manner either at the same time of, or after starting a supply of predetermined types of crystal raw materials as well as before starting a supply of the other predetermined types of crystal raw materials within one cycle wherein all types of the plural types of crystal raw materials are supplied in one time each in the case when plural types of the crystal rawmaterials are alternately supplied in a pulsed manner with maintaining each of predetermined purge times.

Moreover, an impurity doping method for semiconductor wherein a crystal layer made of crystal raw materials is doped with impurities according to the present invention comprises a first impurity raw material and a second impurity material being supplied at close timings in a pulsed manner either at the same time of, orafter starting a supply of the first crystal rawmaterial as well as before starting a supply of the second crystal raw material within one cycle wherein the first and second crystal raw materials are supplied in one time each in the case when the first crystal rawmaterial is supplied alternately with the second crystal raw material in a pulsed manner with maintaining each of predetermined purge times.

As a result, according to the present invention, a carrier concentration comes to increase in case of doping a crystal layer with plural types of impurity raw materials, whereby a semiconductor material having a high conductance can be prepared.

In an impurity doping method for semiconductor of the present invention, it may be arranged in such that a supply of the first impurity raw material is started in synchronous with starting a supply of the first crystal raw material, a supply of the second impurity raw material is started after finishing the supply of the first impurity raw material, and the supply of the second impurity raw material is finished before starting the supply of the second crystal raw material.

Furthermore, in an impurity doping method for semiconductor of the present invention, it may be arranged in such that there is a period of time wherein the first impurity raw material is supplied with the second impurity raw material at the same time.

Moreover, in an impurity doping method for semiconductor of the present invention, it may be arranged in such that a crystal raw material supplied precedently within the one cycle in the crystal raw materials is at least one member selected from the group consisting of Ga, Al, In, B, Zn, and Cd, while a crystal raw material supplied latterly within the one cycle is at least one member selected from the group consisting of N, As, P, S, Se, and Te.

Still further, in an impurity doping method for semiconductor of the present invention, it may be arranged in such that the impurity raw materials are a p-type impurity raw material and an n-type impurity raw material.

Thus, according to the present invention, a p-type semiconductor material with a positive hole of a high density and having a high conductance can be prepared.

Furthermore, an impurity doping method for semiconductor wherein a crystal layer made of crystal raw materials is doped with impurities according to the present invention comprises a cycle composed of a first step wherein a supply of TMGa and (Cp)₂Mg is started at a first timing, and the supply of TMGa and (Cp)₂Mg is finished at a second timing at which the supply of TMGa and (Cp)₂Mg for a predetermined period of time was completed; a second step wherein a supply of TESi is started either immediately after, or after the second timing at which the supply of TMGa and (Cp)₂Mg was finished, and the supply of TESi is finished at a third timing at which the supply of TESi for a predetermined period of time was completed; a third step wherein a supply of NH₃ is started either immediately after, or after the third timing at which the supply of TESi is finished, and the supply of NH₃ is finished at a fourth timing at which the supply of NH₃ for a predetermined period of time was completed; and a fourth step wherein a predetermined purge time is started after the supply of NH₃ is finished at the fourth timing at which the supply of NH₃ was completed, and the predetermined purge time is finished at a fifth timing; being repeated a desired number of times.

Thus, according to the present invention, a carrier concentration comes to increase, a semiconductor material having a high conductance can be prepared in the form of GaN, and further, a p-type semiconductor material with a positive hole of a high density and having a high conductance can be prepared in the case where a GaN crystal layer is doped with Mg and Si as impurity raw materials.

Moreover, a semiconductor material prepared by doping a crystal layer with plural types of impurities according to the present invention comprises the plural types of impurities being disposed closely with each other in the crystal layer at a predetermined ratio.

As a result, according to the present invention, a semiconductor material having a high conductance can be prepared.

Still further, a semiconductor material prepared by doping a crystal layer made of Ga with Mg and Si according to the present invention comprises Mg and Si being disposed closely with each other in the crystal layer made of Ga at a predetermined ratio.

Hence, according to the present invention, a p-type semiconductor material with a positive hole of a high density and having a high conductance can be prepared.

Further, an impurity doping system for semiconductor wherein a crystal layer made of crystal raw materials is doped with impurities according to the present invention comprises a reaction tube to the interior of which is disposed a substrate; a first pipe for supplying NH₃ gas into the reaction tube together with H₂ gas being a carrier gas; a second pipe for supplying TMGa, (Cp)₂Mg, and TESi into the reaction tube together with H₂ gas being a carrier gas; a third pipe for supplying N₂ gas being a carrier gas into the reaction tube; gas valves mounted on the first, second, and third pipes, respectively; a flow rate setting means for setting out each flow rate of gases flowing through the first, second, and third pipes, respectively, to a predetermined value; a heating means for heating the substrate disposed inside the reaction tube; and a control means for controlling closing motions of the gas valves, flow rates set out by the flow rate setting means, heating of the substrate by means of the heating means, and controlling further in such that NH₃ gas is supplied in the reaction tube through the first pipe, TMGa, (Cp) ₂Mg, and TESi are supplied into the reaction tube through the second pipe, and N₂ gas is supplied into the reaction tube through the third pipe at predetermined timings, respectively, in a pulsed manner.

Thus, according to the present invention, a carrier concentration comes to increase, a semiconductor material having a high conductance can be prepared in the form of GaN, and further, a p-type semiconductor material with a positive hole of a high density and having a high conductance can be prepared in the case where a GaN crystal layer is doped with Mg and Si as impurity

### Brief Description of The Drawing

The present invention will become more fully understood from the detailed description given hereinafter and the accompanying drawings which are given by way of illustration only, and thus are not limitative of the present invention, and wherein:
FIG. 1 is a schematic constitutional explanatory view illustrating an essential part of a crystal growth system by which an impurity doping method for semiconductor according to the present invention is realized;
FIG. 2 is an explanatory diagram showing timings for supplying crystal raw materials and impurity raw materials in accordance with an impurity doping method for semiconductor of the present invention;
FIG. 3 is an explanatory view showing schematically a crystal structure of a semiconductor material formed in accordance with an impurity doping method for semiconductor of the present invention;
FIG. 4 is a schematic constitutional explanatory view showing an MOCVD system by which formation of GaN crystal is realized in accordance with an impurity doping method for semiconductor of the present invention;
FIG. 5 is a schematic constitutional explanatory view showing an essential part of the system shown in FIG. 4;
FIG. 6 is a schematic constitutional explanatory view showing the reaction tube of FIG. 4;
FIG. 7 is an explanatory diagram showing timings for supplying crystal raw materials and impurity raw materials in the case where GaN crystal is formed in accordance with an impurity doping method for semiconductor of the present invention;
FIG. 8 is an explanatory view showing schematically a GaN crystal structure formed in accordance with an impurity doping method for semiconductor of the present invention;
FIG. 9 is a graphical representation showing positive hole concentrations of a p-type GaN prepared in accordance with an impurity doping method for semiconductor of the present invention without supplying TESi; and
FIG. 10 is a graphical representation showing positive hole concentrations of a p-type GaN prepared in accordance with an impurity doping method for semiconductor of the present invention.

### Detailed Description of The Preferred Embodiments

In the following, embodiments of an impurity doping method for semiconductor as well as a system therefor and semiconductor materials prepared thereby will be described in detail by referring to the accompanying drawings.

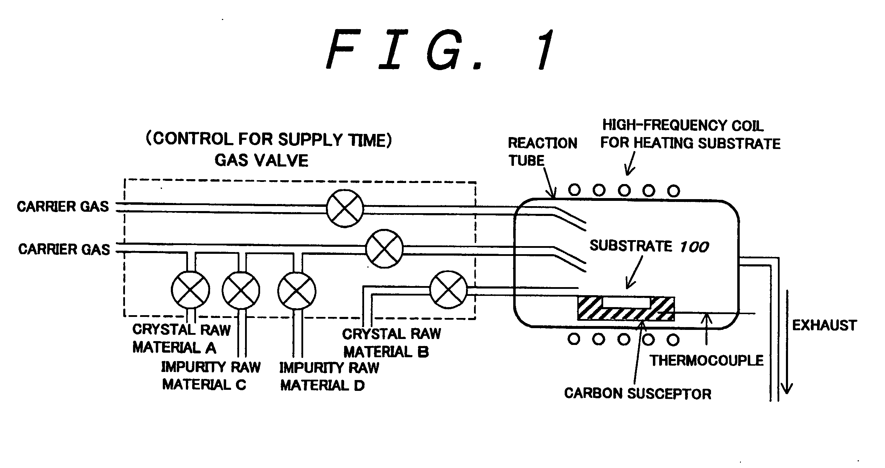

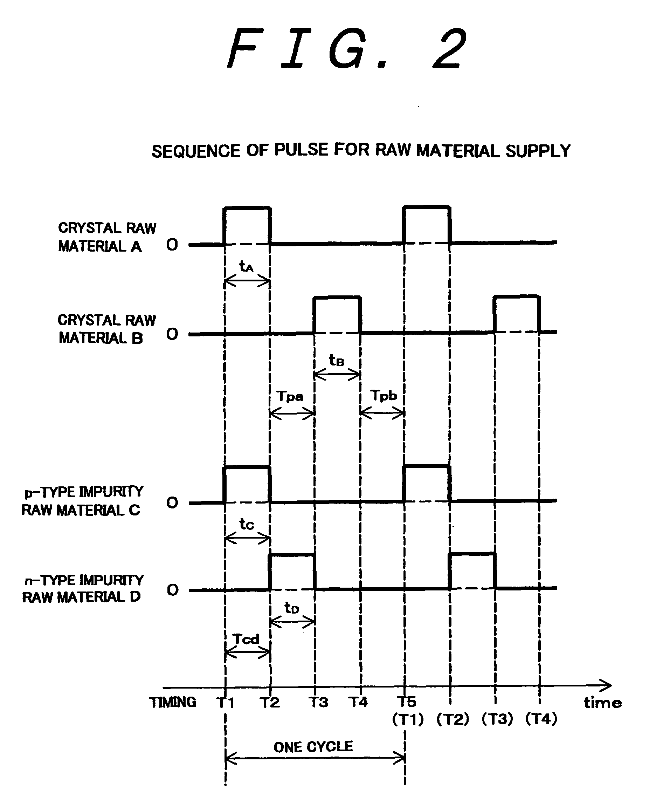

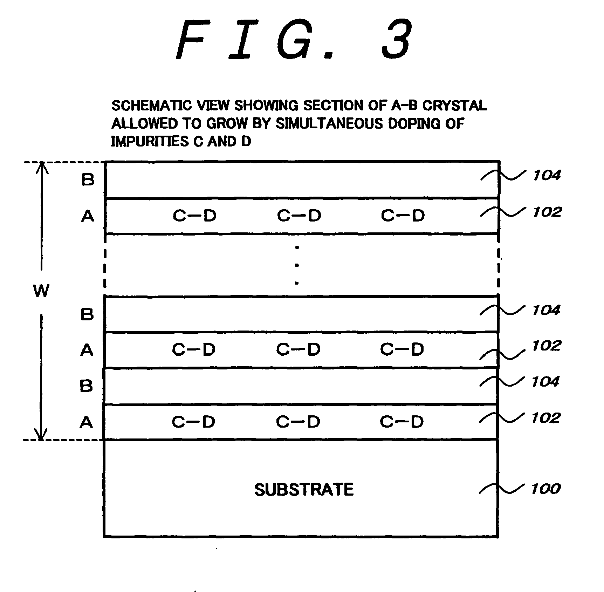

FIG. 1 is a schematic constitutional explanatory view illustrating an essential part of a crystal growth system by which an impurity doping method for semiconductor according to the present invention is realized; FIG. 2 is an explanatory diagram showing timings for supplying crystal raw materials and impurity raw materials in accordance with an impurity doping method for semiconductor of the present invention; and FIG. 3 is an explanatory view showing schematically a crystal structure of a semiconductor material formed in accordance with an impurity doping method for semiconductor of the present invention.

In order to achieve easy understanding of the present invention, an outline of an impurity doping method for semiconductor according to the present invention will be described herein. Into a reaction tube (made of, for example, quartz glass) of a crystal growth system inside of which a substrate has been placed, crystal raw materials and impurity raw materials are supplied respectively in a pulsed manner at each of predetermined timings through pipes (each made of, for example, quartz glass) and the like, so that the crystal raw materials and the impurity raw materials thus supplied react with each other in the reaction tube, whereby a crystal structure is formed on the substrate (see FIG. 1).

Specifically, according to an impurity doping method for semiconductor of the present invention wherein crystal formation is made by the use of a crystal raw material A, a crystal raw material B, a p-type impurity raw material C, and an n-type impurity raw material D (see FIG. 2), all of the crystal raw material A, the crystal raw material B, the p-type impurity raw material C, and the n-type impurity raw material D are not continuously supplied, but supplied for only a predetermined period of time, in other words, supply of these raw materials is stopped for the period of time other than the predetermined time, that is, these raw materials are supplied in a pulsed manner.

Furthermore, the crystal raw material A is alternately supplied with a predetermined purge time Tₚₐ with respect to the crystal raw material B with a predetermined purge time T_{pb} in a pulsed manner. As a result, the crystal raw material A is not supplied at the same timing as that of the crystal raw material B.

On the other hand, the p-type impurity raw material C and the n-type impurity raw material D are supplied either synchronously with the crystal raw material A, or they are supplied after commencement of supplying the crystal raw material A and before commencement of supplying the crystal raw material B in a pulsed manner, besides, the p-type impurity raw material C is supplied with the n-type impurity raw material D at a close timing.

More specifically, the crystal raw material A is started to be supplied, for example, together with the p-type impurity raw material C at timing T1.

Then, the crystal raw material A is supplied at a predetermined time t_{A}, and further the p-type impurity raw material C is supplied for a predetermined time t_{c} being equal to the predetermined time t_{A}, and supply of the crystal raw material A and the p-type impurity raw material C is completed at a timing T2.

Thereafter, immediately after the timing T2 at which supply of the p-type impurity raw material C is completed, supply of the n-type impurity raw material D is started and continued for a predetermined time t_{D}, and the supply of the n-type impurity raw material D is completed at timing T3.

Furthermore, supply of the crystal raw material B is commenced immediately after the timing T3 and continued for a predetermined time t_{B}, and the supply thereof is finished at timing T4.

After completing the supply of the crystal raw material B, a predetermined purge time T_{pb} is taken, and the purge time T_{pb} is finished at timing T5.

Processing of one cycle is completed as described above, and the following cycle is started again wherein the timing T5 is deemed to be a timing T1.

When such cycle as described above is repeated by a desired number of times, crystal having a desired film thickness can be obtained as a semiconductor material.

More specifically, as described above, when a unit of operation wherein one each supply of all the crystal raw material A, the crystal raw material B, the p-type impurity raw material C, and the n-type impurity raw material D is conducted, in other words, when one cycle extending from the timing T1 to the timing T5 is repeated, crystal having a desired thickness is formed.

A timing for supplying the n-type impurity raw material D is not limited to that being immediately after the timing T2 at which a supply of the p-type impurity raw material C was finished, but it may be the timing T1 at which a supply of the p-type impurity raw material C was started.

Namely, a time T_{cd} defined between a timing for starting supply of the p-type impurity raw material C (see the timing T1 in FIG. 2) and a timing for starting supply of the n-type impurity raw material D (see the timing T2 in FIG. 2) may be from zero or longer to a predetermined time t_{c} or shorter wherein there may be a period in which the p-type impurity raw material C is supplied together with the n-type impurity raw material D.

Furthermore, a timing for supplying the p-type impurity raw material C is not limited to that synchronizing with the timing T1 at which a supply of the crystal raw material A was started, but it may be later than the timing T1 at which the crystal raw material A was started.

In brief, the p-type impurity raw material C and the n-type impurity raw material D are supplied at either the same time of starting a supply of the crystal raw material A, or a close timing after the supply thereof and before starting a supply of the crystal raw material B.

A crystal structure formed in accordance with the timings shown in FIG. 2 involves a layer 102 composed of the crystal raw material A formed on a substrate 100 as a result of supplying the crystal raw material A for a predetermined time t_{A} from the timing T1 as shown in FIG. 3.

It is considered in this case that a kind of an impurity pair composed of the p-type impurity raw material C and the n-type impurity raw material D has been formed in the layer 102 made of the crystal raw material A as a result of supplying the p-type impurity raw material C and the n-type impurity raw material D.

Then, a layer 104 made of the crystal raw material B is laminated on the layer 102 made of the crystal raw material A as a result of supplying the crystal raw material B for a predetermined time t_{B} from a timing T3.

Furthermore, when a desired number of times of the above-described one cycle (see FIG. 2) is repeated, lamination of the layer 102 made of the crystal raw material A and the layer 104 made of the crystal raw material B is repeated in response to the number of times of cycle repeated, whereby crystal having a desired thickness W is formed, and thus, the resulting crystal can be used for a semiconductor material.

As described above, it is considered that a kind of an impurity pair is formed from the p-type impurity raw material C and the n-type impurity raw material D in the layer 102 made of the crystal raw material A.

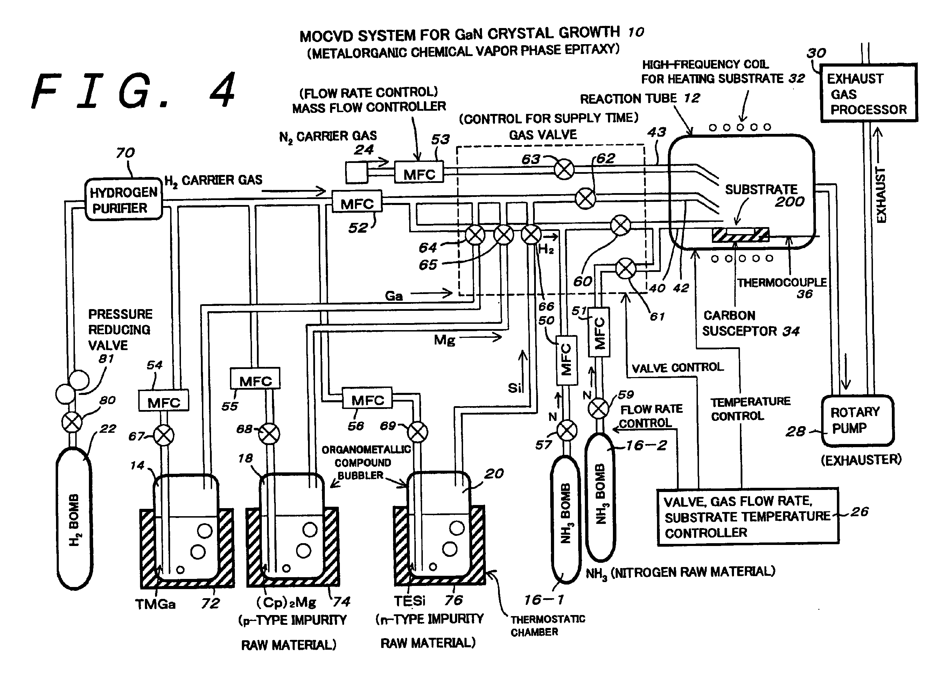

In the following, a case where a layer of GaN crystal as a semiconductor material is formed on a substrate in accordance with an impurity doping method for semiconductor of the present invention will be described by referring to FIG. 4 through 8.

FIG. 4 is a schematic constitutional explanatory view showing a Metalorganic Chemical Vapor Deposition (MOCVD) system by which GaN crystal is formed as a semiconductor material in accordance with an impurity doping method for semiconductor of the present invention.

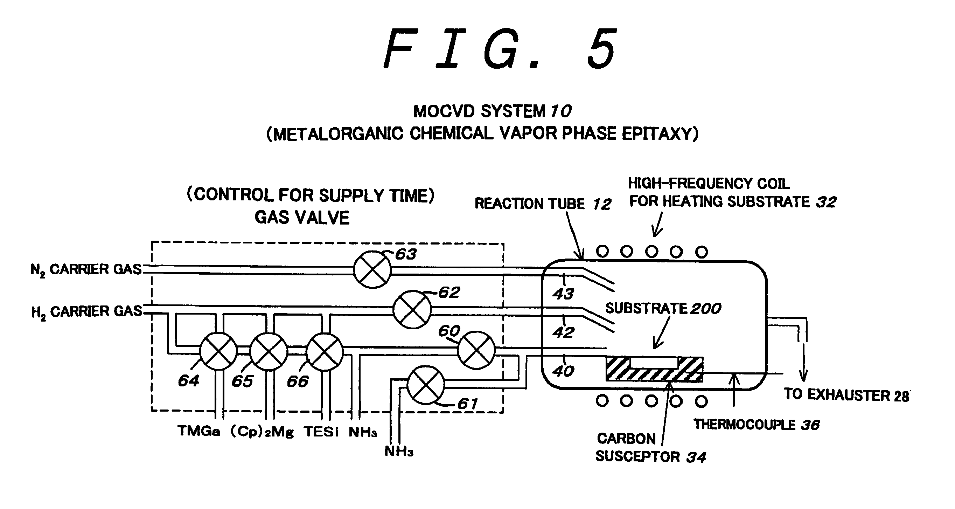

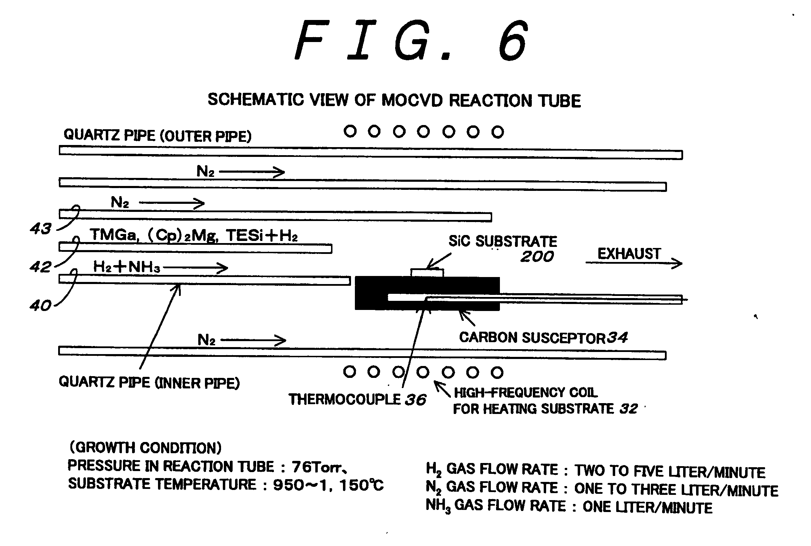

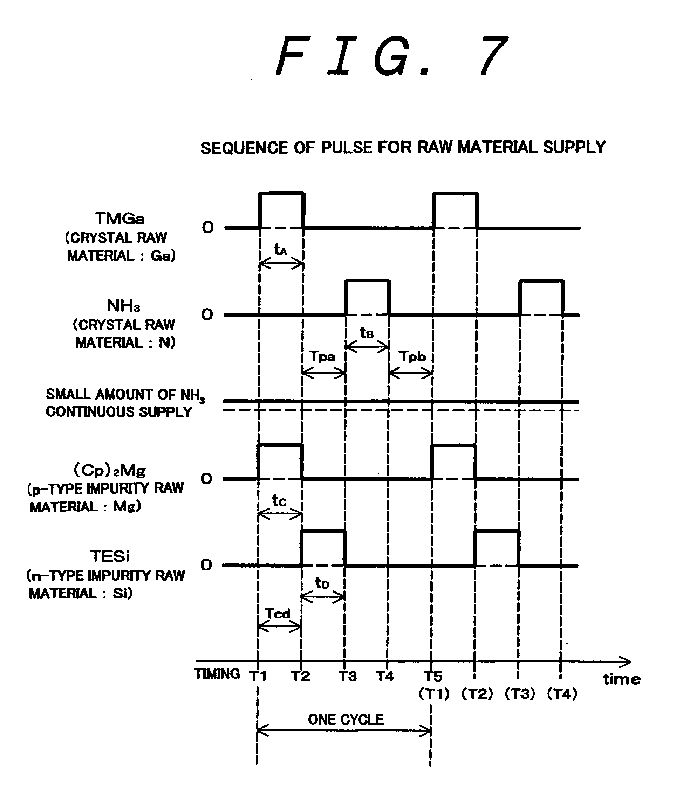

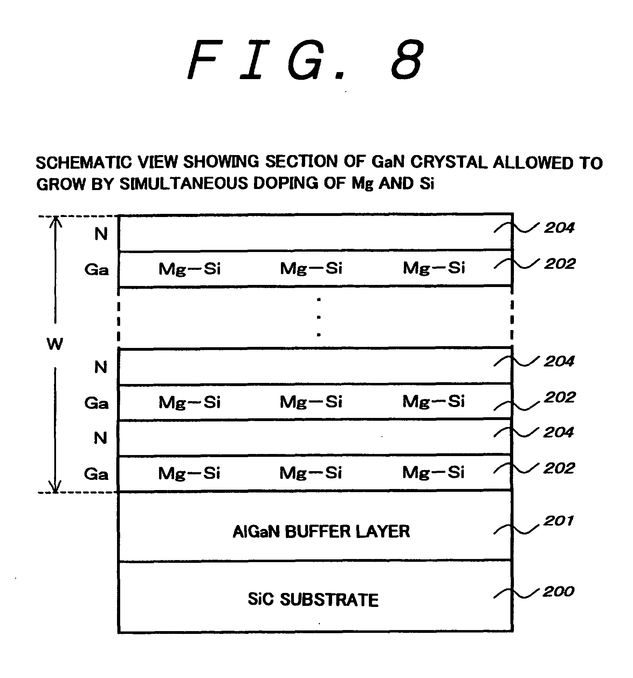

Further, FIG. 5 is a schematic constitutional explanatory view showing an essential part of the system shown in FIG. 4, FIG. 6 is a schematic constitutional explanatory view showing the reaction tube shown in FIG. 4, FIG. 7 is an explanatory diagram showing timings for supplying crystal raw materials and impurity raw materials in the case where GaN crystal is formed in accordance with an impurity doping method for semiconductor of the present invention, and FIG. 8 is an explanatory view showing schematically a GaN crystal structure formed in accordance with an impurity doping method for semiconductor of the present invention.

In the following description, trimethylgallium (TMGa) is used for a raw material gas of gallium (Ga) being a crystal raw material as well as ammonia (NH₃) is used for a raw material gas of nitrogen (N) being a crystal raw material in case of subjecting GaN to crystal growth.

Moreover, biscyclopentadienyl magnesium ((Cp)₂Mg) is used for a raw material gas of magnesium (Mg) being an impurity material (p-type impurity raw material) for doping use, while tetraethylsilane (TESi) is used for a raw material gas of silicon (Si) being an impurity material (n-type impurity raw material) for doping use.

First, an outline of an MOCVD system 10 shown in FIG. 4 is explained. The MOCVD system 10 comprises a reaction tube 12 the inside of which is provided with a substrate 200, a bubbler 14 for retaining trimethylgallium (TMGa), NH₃ bombs 16-1 and 16-2 each for retaining ammonia (NH₃) gas, a bubbler 18 for retaining biscyclopentadienyl magnesium ((Cp)₂Mg), a bubbler 20 for retaining tetraethylsilane (TESi), an H₂ bomb 22 for retaining hydrogen (H₂) gas being a carrier gas, an N₂ bomb 24 for retaining nitrogen (N₂) gas being a carrier gas, a controller 26 for effecting a variety of controls (for example, a control for closing motions of the undermentioned various gas valves and pressure regulators, a control for the undermentioned various mass flow controllers for the sake of setting a flow rate in a variety of gases introduced into the reaction tube 12 to a predetermined value, a control for temperature of the substrate 200 based on a control for energization of high-frequency current upon the undermentioned high-frequency coil 32 for heating substrate, and the like controls), a rotary pump 28 used as an exhauster for implementing exhaust inside the reaction tube, and an exhaust gas processor 30 for processing exhaust from the rotary pump 28.

In the above-described constitution, the high-frequency coil 32 for heating substrate is wound around the outer circumferential region of the reaction tube 12. Inside the reaction tube 12, a carbon susceptor 34 for supporting the substrate 200 is disposed, and a thermocouple 36 to be mounted to the carbon susceptor 34 is disposed.

Namely, high-frequency current is energized upon the high-frequency coil 32 for heating substrate to heat the carbon susceptor 34, whereby the substrate 200 mounted on the carbon susceptor 34 is heated to a predetermined temperature in the MOCVD system 10.

A temperature of the carbon susceptor 34 is monitored by the thermocouple 36, and a high-frequency current energized to the high-frequency coil 32 for heating substrate is controlled by means of the controller 26 based on results of the monitoring, whereby a temperature of the substrate 200 is controlled in such a manner that the substrate 200 is heated to a predetermined temperature.

Moreover, a quartz pipe 40 for supplying NH₃ gas from the NH₃ bombs 16-1 and 16-2 into the reaction tube 12, a quartz pipe 42 for supplying H₂ gas as a carrier gas from the H₂ bomb 22, and a quartz pipe 43 for supplying N₂ gas as a carrier gas from the N₂ bomb 24 are disposed in the reaction tube 12, respectively.

The NH₃ gas retained in the NH₃ bombs 16-1 and 16-2 is adapted in such that when gas valves 57, 59, 60, and 61 are opened respectively, it is supplied into the reaction tube 12 together with H₂ gas at a gas flow rate which has been set to each predetermined value by means of mass flow controllers (MFCs) 50 and 51 through the quartz pipe 40.

Furthermore, the H₂ gas retained in the H₂ bomb 22 is adapted in such that when gas valves 67, 68, and 69 are opened, it is delivered from a hydrogen purifier 70 through a gas valve 80 and a pressure reducing valve 81 to the bubblers 14, 18, and 20 at a gas flow rate which has been set to each predetermined value by means of MFCs 54, 55, and 56.

In this case, the bubbler 14 is provided with a thermostatic chamber 72, the bubbler 18 is provided with a thermostatic chamber 74, and the bubbler 20 is provided with a thermostatic chamber 76, respectively. When the gas valves 64, 65, and 66 are opened together with the gas valve 62, the TMGa, the (Cp)₂Mg, and the TESi retained in the bubblers 14, 18, and 20 and maintained at a predetermined temperature, respectively, are supplied together with an H₂ carrier gas at a gas flow rate which has been set to a predetermined value by means of the MFC 52 into the reaction tube 12 through the quartz pipe 42, respectively.

On one hand, the N₂ gas retained in the N₂ bomb 24 is adapted in such that when the gas valve 63 is opened, it is supplied into the reaction tube 12 at a gas flow rate which has been set to a predetermined value by means of the MFC 53 through the quartz pipe 43.

Controls for gas flow rates by means of the MFCs 50, 51, 52, 53, 54, 55, and 56 as well as controls for closing motions of the gas valves 57, 59, 60, 61, 62, 63, 64, 65, 66, 67, 68, 69, and 80 as well as for closing motions of the pressure reducing valve 81 are made by means of the controller 26.

In the above-described constitution, first, a pressure in the reaction tube 12 is reduced to 76 Torr (0.1 atmospheric pressure), and a temperature of the substrate 200 (SiC (silicon carbide) substrate is used for the substrate 200) mounted on the carbon susceptor 34 is heated to 950°C in the MOCVD system 10 for forming GaN crystal as a semiconductor material in accordance with an impurity doping method for semiconductor of the present invention.

Furthermore, the controller 26 controls the MFCs 50, 51, 52, and 53, whereby a flow rate of NH₃ gas is controlled to one liter/minute, a flow rate of H₂ gas is controlled to two to five liter/minute, and a flow rate of N₂ gas is controlled to one to three liter/minute, respectively.

Namely, it is preferred that an internal pressure in the reaction tube 12 is reduced to 0.1 atmospheric pressure, and each flow rate of various raw material gases is made to be several meters/second in order to keep each switching time of the various raw material gases (TMGa gas for supplying Ga as a crystal raw material, NH₃ gas for supplying N as a crystal rawmaterial, (CP)₂Mg gas for supplying Mg as a p-type impurity raw material, and TESi gas for supplying Si as an n-type impurity raw material) one-tenth second or faster on the SiC substrate 200 in the reaction tube 12.

It is to be noted that an AlGaN buffer layer 201 (see FIG. 8) has been previously formed with a thickness of 300 nm at 1150°C on the SiC substrate 200 mounted on the carbon susceptor 34 in accordance with a well-known technique.

As shown in FIG. 7, TMGa and NH₃ are alternately supplied for one second each to form GaN crystal while maintaining each of one-second purge times Tₚₐ and T_{pb}. In this case, (Cp)₂Mg of a p-type impurity raw material is supplied for the same period of time as that of the TMGa, while TESi of an n-type impurity raw material is supplied for one second after supplying the (Cp)₂Mg, i.e., during only the purge time Tₚₐ.

In order to prevent such a phenomenon that nitrogen atom is vaporized again from the GaN crystal formed during stopping a supply of NH₃ under a high temperature, resulting in deterioration of quality in the crystal formed, a low flow rate (50 cc) of NH₃ is continuously supplied.

More specifically, a supply of TMGa and (Cp)₂Mg is first started at a timing T1.

The TMGa is supplied for one second (a predetermined time t_{A}) as well as the (Cp)₂Mg is supplied for one second (a predetermined time t_{c}) equal to a predetermined time t_{A}, and the supply of the TMGa and the (Cp)₂Mg is finished at a timing T2.

Thereafter, a supply of TESi is started immediately after the timing T2 at which supply of (Cp)₂Mg is finished, the TESi is supplied for one second (a predetermined time t_{D}), and the supply of TESi is finished at a timing T3.

Furthermore, a supply of NH₃ is started immediately after the timing T3, the NH₃ is supplied for one second (a predetermined time t_{B}), and the supply of NH₃ is finished at timing T4.

After finishing the supply of NH₃, a predetermined purge time T_{pb} (one second) is executed, and the purge time T_{pb} is finished at timing T5.

Processing of one cycle is completed in accordance with the above-described manner, and the following cycle is started from the timing T5 as timing T1.

When such cycle as described above is repeated by a desired number of times, GaN crystal having a desired film thickness can be obtained as a semiconductor material.

In a structure of GaN crystal formed in accordance with the timings shown in FIG. 7, a layer 202 made of Ga is formed on the AlGaN buffer layer 201 prepared on the SiC substrate 200 by means of a supply of TMGa for one second (a predetermined time t_{A}) from a timing T1 as shown in FIG. 8.

In this case, a kind of impurity pair (Mg-Si) made from Mg being a p-type impurity rawmaterial and Si being an n-type impurity raw material is formed in a layer 202 made of Ga as a result of supplying Mg of (Cp)₂Mg being a p-type impurity raw material and Si of TESi being an n-type impurity raw material.

Then, a layer 204 made of N is laminated on the layer 202 made of Ga as a result of supplying NH₃ in case of starting from the timing T3 (a predetermined time t_{B}).

One cycle wherein TMGa, NH₃, (Cp)₂Mg and TESi are supplied (see FIG. 7) in accordance with a manner as described above corresponds to four seconds, so that when a desired number of times for this one cycle is repeated, lamination of the layer 202 made of Ga and the layer 204 made of N is repeated in response to a repeated number of times for the cycle, GaN crystal having a desired thickness W is formed, whereby the GaN crystal prepared may be used as a semiconductor.

More specifically, when a raw material gas (Cp)₂Mg of Mg being a p-type impurity raw material and a raw material gas TESi of Si being an n-type impurity raw material are supplied in a pulsed manner at a close timing either at the same time of starting a supply of a raw material gas TMGa of Ga being a crystal raw material gas, or after the supply thereof and before starting a supply of a raw material gas NH₃ of N being a crystal raw material as described above, the layer 202 made of Ga is doped with Mg and Si at an appropriate ratio without incorporating disorderly Mg and Si into the layer.

Thus, positions of Mg and Si in the layer 202 made of Ga are controlled, whereby Mg and Si are placed at a close relationship with each other at a predetermined ratio in the layer 202 made of Ga, so that Mg forms a kind of impurity pair with Si, and it results in decrease of energy level, i.e., decrease of activation energy.

Accordingly, a carrier concentration increases in GaN crystal, whereby a semiconductor material having a high conductance can be obtained.

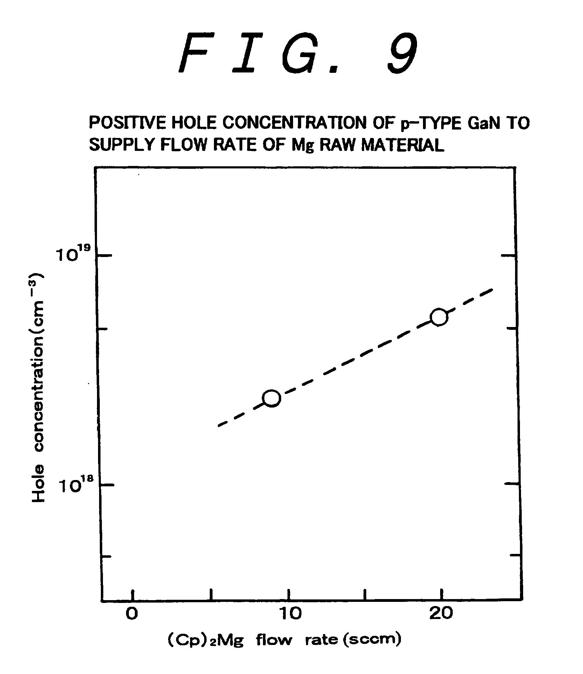

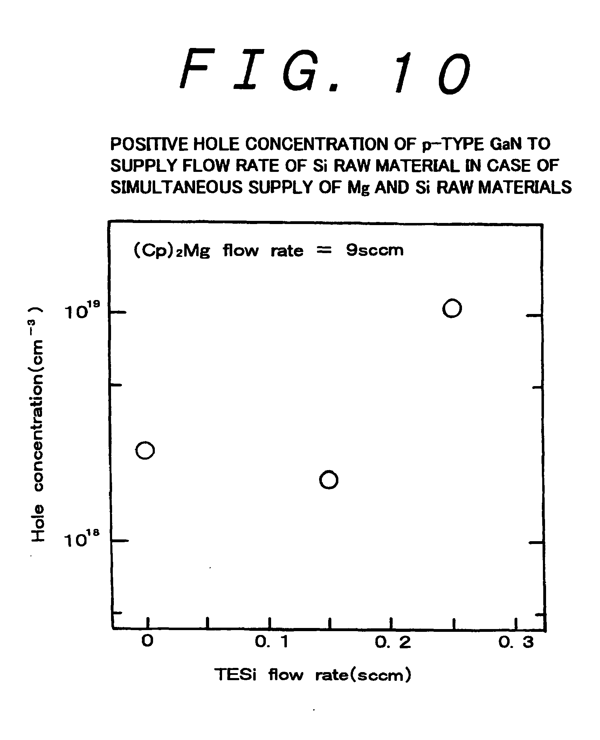

Furthermore, FIGS. 9 and 10 indicate experimental results made by the present applicant in accordance with a constitution of the system as well as conditions therefor shown in FIGS. 4 through 7.

The experimental results of FIGS. 9 and 10 are represented by graphs each indicating positive hole concentrations of p-type GaN prepared in accordance with an impurity doping method for semiconductor of the present invention. It is to be noted that the p-type GaN used in the experiment shown in FIG. 9 is the ones each having a crystal structure prepared in accordance with the above-described timings shown in FIG. 7, but no raw material gas TESi of Si being an n-type impurity raw material has not been supplied (for a predetermined time t_{D}), and it has been prepared by changing only a supply flow rate of a raw material gas (Cp)₂Mg of Mg being a p-type impurity raw material.

As shown in FIG. 9, when GaN crystal is prepared as a semiconductor material by supplying only one impurity raw material (Mg) without using plural types of impurity raw materials in accordance with an impurity doping method for semiconductor of the present invention, a carrier concentration of p-type GaN is 2.6 x 10¹⁸ cm⁻³ in case of 9 sccm supply flow rate of (Cp)₂Mg, while a carrier concentration of p-type GaN is 5.4 x 10¹⁸ cm⁻³ in case of 20 sccm supply flow rate of (Cp)₂Mg.

Accordingly, it is found that a carrier concentration of p-type GaN increases in proportion to a supply flow rate of (Cp)₂Mg within a range of from 9 sccm to 20 sccm of a raw material gas (Cp)₂Mg of Mg being a p-type impurity raw material.

In the following, an explanation will be made by referring to the experimental results shown in FIG. 10, these results are represented by a graph indicating concentrations of positive hole of p-type GaN prepared in accordance with an impurity doping method for semiconductor of the present invention. It is to be noted that thep-type GaN shown in FIG. 10 has a crystal structure prepared in accordance with the above-described timings shown in FIG. 7 wherein raw material gas (Cp)₂Mg of Mg being a p-type impurity raw material is supplied constantly at 9 sccm and at the same time, a supply flow rate of raw material gas TESi of Si being an n-type impurity raw material is changed.

As shown in FIG. 10, when a semiconductor material is prepared by supplying plural types of impurity raw materials (Mg and Si) in accordance with an impurity doping method for semiconductor of the present invention, a carrier concentration of p-type GaN is 1.9 x 10¹⁸ cm⁻³ in case of 0.15 sccm supply flow rate of TESi, while a carrier concentration of p-type GaN is 1.1 x 10¹⁹ cm⁻³ in case of 0.25 sccm supply flow rate of TESi.

Accordingly, when TESi is not supplied in the case where a supply flow rate of (Cp)₂Mg is 9 sccm (see FIG. 9), a carrier concentration of p-type GaN is 2.6 x 10¹⁸ cm⁻³, while when TESi is supplied at 0.25 sccm (see FIG. 10), a carrier concentration of p-type GaN is 1.1 x 10¹⁹ cm⁻³, so that a carrier concentration of the p-type GaN becomes about four times higher.

As described above, an impurity doping method for semiconductor according to the present invention comprises each of plural types of impurity raw materials being supplied at close timings in a pulsed manner either at the same time of, or after starting a supply of either types of crystal raw materials as well as before starting a supply of the other types of crystal raw materials in the case when the plural types of the crystal raw materials are alternately supplied in a pulsed manner with maintaining each of predetermined purge times Tₚₐ and T_{pb}. Accordingly, a crystal layer is doped with the plural types of impurities at a proper ratio without incorporating disorderly the plural types of impurities into an atomic layer of a crystal formed on a substrate from the crystal raw materials, whereby a carrier concentration is increased in even the case where p-type impurity rawmaterials andn-type impurity rawmaterials are used, so that it becomes possible to prepare a semiconductor material having a high conductance.

Furthermore, according to an impurity doping method for semiconductor of the present invention, since decrease in activation energy is intended in even a p-type semiconductor material an impurity level of which in forbidden gap is deep and having high activation energy, such a semiconductor material wi th positive hole of a high density and having a high conductance can be prepared.

Moreover, according to an impurity doping method for semiconductor of the present invention, since it has been constituted in such that plural types of impurities are supplied at close timings in a pulsed manner, but not supplied continuously, an amount of each impurity raw material to be incorporated into an atomic layer of crystal formed on a substrate from crystal raw materials can be controlled, so that it becomes possible to prepare a semiconductor material wherein the interior of the atomic layer in the crystal is doped with impurities at each proper ratio, whereby a carrier concentration thereof is increased.

For this reason, such a theoretical concept that two types of impurities are supplied at each proper ratio, whereby an impurity level is changed to result in increase of a ratio of activation can be realized by an impurity doping method for semiconductor according to the present invention.

Still further, since a semiconductor material having a high conductance, particularly a p-type semiconductor material with positive hole of a high density and having a high conductance can be prepared by an impurity doping method for semiconductor according to the present invention as described above, it becomes possible to realize p-n junction of a high efficiency, so that it can contribute to elevation of semiconductor device characteristics such as increase in injection efficiency of p-n junction, decrease in contact resistance, and decrease in series resistance.

The above-described embodiments may be modified as in the manners explained in the following paragraphs (1) through (4).

(1) Although each of the above-described embodiments has been described in the case where GaN crystal is prepared, the invention is not limited thereto as a matter of course, a semiconductor material may be prepared from a variety of crystals such as AlGaN crystal, and InGaN crystal by employing either the above-described MOCVD system 10, or the other crystal growth apparatuses in accordance with an impurity doping method for semiconductor of the present invention.

In this case, a variety of conditions may be changed. For instance, when it is intended to prepare AlGaN crystal, TMAl may have been retained in the bubbler 14 in place of TMGa, while TMIn may have been retained in the bubbler 14 in the case where formation of InGaN crystal is intended.

(2) Although Ga and B have been used as each of crystal raw materials A and B as well as Mg and Si have been used as each of impurity raw materials C and D, respectively, in those of FIGS . 1 through 3 in each of the above-described embodiments, the invention is not limited thereto, as a matter of course.

For instance, the groups III and II elements such as Al, In, B, Zn, and Cd may be used other than Ga as a crystal raw material A, the groups V and VI elements such as As, P, S, Se, and Te may be used other than N as a crystal raw material B, Be may be used other than Mg as an impurity raw material C, and O may be used other than Si as an impurity raw material D.

Furthermore, not only a single type of material, but also two or more types of materials may be used with respect to the crystal raw materials A and B, respectively. For instance, when a mixed crystal composed of crystal raw materials A and A' as well as crystal raw materials B and B' is formed also, a semiconductor material may be prepared by adding required changes to an impurity doping method for semiconductor according to the present invention.

(3) Although it has been arranged in each of the above-described embodiments in such that a supply of an n-type impurity raw material D (TESi) is started immediately after a timing T2 at which a supply of a p-type impurity raw material C ((Cp)₂Mg) is finished, the invention is not limited thereto as a matter of course, but it may be arranged in such that a supply of the n-type impurity raw material D (TESi) is started after finishing a supply of the p-type impurity raw material C ((Cp)₂Mg) through a predetermined purge time.

While it has been arranged in each of the above-described embodiments in such that a supply of crystal raw material B (NH₃) is started immediately after a timing T3 at which a supply of an n-type impurity raw material D (TESi) is finished, the invention is not limited thereto as a matter of course, but it may be arranged in such that a supply of the crystal raw material D (NH₃) is started after finishing a supply of the n-type impurity raw material D (TESi) through a predetermined purge time.

(4) Each of the above-described embodiments may properly becombinedwiththeabove-describedmodifiedexamples (1) through (3), respectively.

Since the present invention has been constitutedas described above, such an excellent advantage that a semiconductor material having a high conductance can be prepared as a result of increasing a carrier concentration even in the case where a crystal layer is doped with p-type impurity raw materials and n-type impurity raw materials.

Moreover, there is such an excellent advantage that a p-type semiconductor material with positive hole of a high density and having a high conductance can be prepared.

## Claims

1. An impurity doping method for semiconductor wherein a crystal layer made of crystal raw materials is doped with impurities,
**characterized in**
**that** said method comprises a step of:
a supply of different doping types of impurity raw materials at close timings in a pulsed manner within one cycle wherein all types of said crystal raw materials are supplied in one time each in the case when plural types of said crystal raw materials are alternately supplied in a pulsed manner with maintaining each of predetermined purge times.

2. The impurity doping method for semiconductor according to claim 1, **characterized in that** said different doping types of impurity raw materials being supplied at close timings in a pulsed manner either at the same time of, or after starting a supply of predetermined types of crystal raw materials as well as before starting a supply of the other predetermined types of crystal raw materials within said one cycle.

3. The impurity doping method for semiconductor according to claim 2, **characterized in that** said different doping types of impurity raw materials comprises a first impurity raw material of a first doping type and a second impurity material of a second doping type being different to the first doping type, which are supplied at close timings in a pulsed manner either at the same time of, or after starting a supply of a first crystal raw material as well as before starting a supply of a second crystal raw material within one cycle wherein said first and second crystal raw materials are supplied in one time each in the case when said first crystal raw material is supplied alternately with said second crystal raw material in a pulsed manner with maintaining each of predetermined purge times.

4. The impurity doping method for semiconductor according to claim 3, **characterized in that** a supply of said first impurity raw material is started in synchronous with starting a supply of said first crystal raw material, a supply of said second impurity raw material is started after finishing the supply of said first impurity raw material, and the supply of said second impurity raw material is finished before starting the supply of said second crystal raw material.

5. The impurity doping method for semiconductor according to claim 3, **characterized in that** there is a period of time wherein said first impurity raw material is supplied with said second impurity raw material at the same time.

6. The impurity doping method for semiconductor according to any of claims 1 to 5, **characterized in that** a crystal raw material supplied precedently within said one cycle in said crystal raw materials is at least one member selected from the group consisting of Ga, Al, In, B, Zn, and Cd, while a crystal raw material supplied latterly within said one cycle is at least one member selected from the group consisting of N, As, P, S, Se, and Te.

7. The impurity doping method for semiconductor according to any of claims 1 to 6, **characterized in that** said different doping types of impurity raw materials are a p-type impurity raw material and an n-type impurity raw material.

8. The impurity doping method for semiconductor according to any of claims 1 to 7, **characterized in**
**that** said different doping types of impurity raw materials are comprised of (Cp)₂Mg being a first impurity raw material and TESi being a second impurity raw material,
**that** said plural types of crystal raw materials are comprised of TMGa being a first crystal raw material and NH₃ being a second crystal raw material;
**that** said cycle comprises the steps of:
(a) supplying TMGa and (Cp)₂Mg at a first timing,
(b) finishing the supply of TMGa and (Cp)₂Mg at a second timing at which the supply of TMGa and (Cp)₂Mg for a predetermined period of time was completed;
(c) supplying TESi either immediately after, or after the second timing at which the supply of TMGa and (Cp)₂Mg was finished,
(d) finishing the supply of TESi at a third timing at which the supply of TESi for a predetermined period of time was completed;
(e) supplying NH₃ either immediately after, or after the third timing at which the supply of TESi is finished,
(f) finishing the supply of NH₃ at a fourth timing at which the supply of NH₃ for a predetermined period of time was completed;
(g) starting a predetermined purge time after the supply of NH₃ at the fourth timing at which the supply of NH₃ was completed,
(h) finishing said predetermined purge time at a fifth timing; and
**that** said cycle being repeated a desired number of times.

9. A semiconductor material (100-104; 200-204)comprising a crystal layer (102; 202) **characterized in that** said crystal layer (102; 202) has different doping types of impurities (C-D; Mg-Si) which are disposed closely with each other in said crystal layer (102; 202) at a predetermined ratio.

10. The semiconductor material according to claim 9, **characterized in that** said crystal layer is made of Ga and comprises Mg and Si being different doping types of impurities, which are disposed closely with each other in said crystal layer made of Ga at a predetermined ratio.

## Patentansprüche

1. Ein Verfahren zur Dotierung eines Halbleiters mit Verunreinigungen, wobei eine aus einem Kristallrohmaterial hergestellte Kristalllage mit Verunreinigungen dotiert wird,
**dadurch gekennzeichnet, dass**
das Verfahren die Schritte enthält:
eine Zuführung verschiedener Dotierungstypen von Verunreinigungsrohmaterialien in enger Taktung in einer gepulsten Art in demselben Arbeitsgang, wobei alle Typen des besagten Kristallrohmaterials jeweils einmal zugeführt werden, unter Aufrechterhaltung von jeweils vorbestimmten Spülzeiten im Falle dass mehrere Typen des Kristallrohmaterials alternierend in einer gepulsten Weise zugeführt werden.

2. Verfahren zur Dotierung eines Halbleiters mit Verunreinigungen nach Anspruch 1, **dadurch gekennzeichnet, dass** die verschiedenen Dotierungstypen von Verunreinigungsrohmaterialien in enger Taktung in einer gepulsten Art, entweder zeitgleich mit, oder nach Beginn einer Zuführung vorherbestimmter Typen des Kristallrohmaterials, sowie vor Beginn einer Zuführung anderer vorherbestimmten Typen des Kristallrohmaterials in demselben Arbeitsgang zugeführt werden.

3. Verfahren zur Dotierung eines Halbleiters mit Verunreinigungen nach Anspruch 2, **dadurch gekennzeichnet, dass** die verschiedenen Dotierungstypen von Verunreinigungsrohmaterialien ein erstes Verunreinigungsrohmaterial eines ersten Dotierungstypes und ein zweites Verunreinigungsrohmaterial eines zweiten Dotierungstypes, welches unterschiedlich von dem ersten Dotierungstyp ist, enthalten, welche in enger Taktung in einer gepulsten Art entweder zeitgleich mit, oder nach Beginn einer Zuführung eines ersten Kristallrohmaterials sowie vor Beginn einer Zuführung eines zweiten Kristallrohmaterials in demselben Arbeitsgang zugeführt werden, wobei das erste und das zweite Kristallrohmaterial jeweils einmal zugeführt wird, unter Aufrechterhaltung von jeweils vorbestimmten Spülzeiten im Falle, dass das erste Kristallrohmaterial alternierend mit dem zweiten Kristallrohmaterial in einer gepulsten Weise zugeführt wird.

4. Verfahren zur Dotierung eines Halbleiters mit Verunreinigungen nach Anspruch 3, **dadurch gekennzeichnet, dass** eine Zuführung des ersten Verunreinigungsrohmaterials begonnen wird synchron mit Beginn einer Zuführung des ersten Kristallrohmaterials, eine Zuführung des zweiten Verunreinigungsrohmaterials begonnen wird nach Abschluss der Zuführung des ersten Verunreinigungsrohmaterials, und die Zuführung des zweiten Verunreinigungsrohmaterials abgeschlossen wird vor Beginn der Zuführung des zweiten Kristallrohmaterials.

5. Verfahren zur Dotierung eines Halbleiters mit Verunreinigungen nach Anspruch 3, **dadurch gekennzeichnet, dass** es einen Zeitraum gibt in dem das erste Verunreinigungsrohmaterial gleichzeitig zusammen mit dem zweiten Verunreinigungsrohmaterial zugeführt wird.

6. Verfahren zur Dotierung eines Halbleiters mit Verunreinigungen nach einem der Ansprüche 1 bis 5, **dadurch gekennzeichnet, dass** ein vorangehend in dem besagten selben Arbeitsgang zugeführtes Kristallrohmaterial von den besagten Kristallrohmaterialien zumindest ein Mitglied ausgewählt aus der Gruppe bestehend aus Ga, Al, In, B, Zn, und Cd ist, wobei ein Kristallrohmaterial das später in dem besagten selben Arbeitsgang zugeführt wird, zumindest ein Mitglied ausgewählt aus der Gruppe bestehend aus N, As, P, S, Se, and Te ist.

7. Verfahren zur Dotierung eines Halbleiters mit Verunreinigungen nach einem der Ansprüche 1 bis 6, **dadurch gekennzeichnet, dass** besagte verschiedene Dotierungstypen von Verunreinigungsrohmaterialien ein p-Typ Verunreinigungsrohmaterial und ein n-Type Verunreinigungsrohmaterial sind.

8. Verfahren zur Dotierung eines Halbleiters mit Verunreinigungen nach einem der Ansprüche 1 bis 7, **dadurch gekennzeichnet, dass** besagte verschiedene Dotierungstypen von Verunreinigungsrohmaterialien (Cp)₂Mg als erstes Verunreinigungsrohmaterial und TESi als zweites Verunreinigungsrohmaterial enthalten,
dass besagte mehrere Typen von Kristallrohmaterialien TMGa als erstes Kristallrohmaterial und NH₃ als zweites Kristallrohmaterial enthalten;
dass besagter Arbeitsgang die Schritte enthält:
(a) Zuführen von TMGa und (Cp)₂Mg zu einem ersten Zeitpunkt
(b) Beenden der Zuführung von TMGa und (Cp)₂Mg zu einem zweiten Zeitpunkt nachdem die Zuführung mit TMGa und (Cp)₂Mg über einen vorgegebene Zeitraum abgeschlossen ist;
(c) Zuführen von TESi entweder direkt danach, oder nach dem zweiten Zeitpunkt nachdem die Zuführung von TMGa und (Cp)₂Mg abgeschlossen ist,
(d) Beenden der Zuführung von TESi zu einem dritten Zeitpunkt nachdem die Zuführung von TESi über einen vorgegebene Zeitraum abgeschlossen ist;
(e) Zuführen von NH₃ entweder direkt danach, oder nach dem dritten Zeitpunkt nachdem die Zuführung von TESi abgeschlossen ist,
(f) Beenden der Versorgung mit NH₃ zu einem vierten Zeitpunkt nachdem die Zuführung von NH₃ über einen vorgegebene Zeitraum abgeschlossen ist;
(g) Beginn einer vorgegebenen Spülzeit nachdem die Zuführung von NH₃ zum vierten Zeitpunkt abgeschlossen ist,
(h) Beenden der vorgegebenen Spülzeit zu einem fünften Zeitpunkt; und dass der Arbeitsgang in einer gewünschten Häufigkeit wiederholt wird.

9. Ein Halbleitermaterial (100-104; 200-204) enthaltend eine Kritalllage (102; 202), **dadurch gekennzeichnet, dass** besagte Kristalllage (102; 202) verschiedene Dotierungstypen von Verunreinigungen (C-D: Mg-Si) hat, welche in einem vorherbestimmten Verhältnis nah zueinander in besagter Kristallage (102; 202) sind.

10. Halbleitermaterial nach Anspruch 9, **dadurch gekennzeichnet, dass** besagte Kristalllage aus Ga gemacht ist und als verschiedene Dotierungstypen von Verunreinigungen Mg und Si enthält, die in einem vorherbestimmten Verhältnis nah zueinander in besagter Kristalllage, welche aus Ga gemacht ist, sind.

## Revendications

1. Procédé de dopage pour semi-conducteur avec impuretés, étant précisé qu'une couche de cristal composée de matériaux bruts de cristal est dopée avec des impuretés,
**caractérisé en ce que** ledit procédé comprend une étape qui consiste :
à fournir différents types de matériaux bruts d'impuretés pour dopage à un rythme rapproché, d'une manière pulsée à l'intérieur d'un cycle, étant précisé que tous les types de matériaux bruts de cristal sont fournis en une fois chacun dans les cas où plusieurs types de ces matériaux bruts de cristal sont fournis en alternance d'une manière pulsée, avec le maintien de durées de purge prédéterminées.

2. Procédé de dopage pour semi-conducteur selon la revendication 1, **caractérisé en ce que** les différents types de matériaux bruts d'impuretés pour dopage sont fournis à des rythmes rapprochés d'une manière pulsée, en même temps qu'une fourniture de types prédéterminés de matériaux bruts de cristal ou après le démarrage de celle-ci, et avant le démarrage d'une fourniture des autres types prédéterminés de matériaux bruts de cristal à l'intérieur du cycle.

3. Procédé de dopage pour semi-conducteur selon la revendication 2, **caractérisé en ce que** les différents types de matériaux bruts d'impuretés pour dopage comprennent un premier matériau d'impuretés d'un premier type de dopage, et un second matériau d'impuretés d'un second type de dopage, différent du premier type de dopage, qui sont fournis à des rythmes rapprochés d'une manière pulsée, en même temps qu'une fourniture d'un premier matériau brut de cristal ou après le démarrage de celle-ci, et avant le démarrage d'une fourniture d'un second matériau brut de cristal à l'intérieur du cycle, étant précisé que les premier et second matériaux bruts de cristal sont fournis en une seule fois chacun dans les cas où le premier matériau brut de cristal est fourni en alternance avec le second matériau brut de cristal d'une manière pulsée, avec le maintien de chacune des durées de purge prédéterminées.

4. Procédé de dopage pour semi-conducteur selon la revendication 3, **caractérisé en ce qu'**une fourniture du premier matériau brut d'impuretés est démarrée de manière synchrone avec le démarrage d'une fourniture du premier matériau brut de cristal, une fourniture du second matériau brut d'impuretés est démarrée après la fin de la fourniture du premier matériau brut d'impuretés, et la fourniture du second matériau brut d'impuretés est terminée avant le démarrage de la fourniture du second matériau brut de cristal.

5. Procédé de dopage pour semi-conducteur selon la revendication 3, **caractérisé en ce qu'**il y a une période pendant laquelle le premier matériau brut d'impuretés est fourni en même temps que le second matériau brut d'impuretés.

6. Procédé de dopage pour semi-conducteur selon l'une quelconque des revendications 1 à 5, **caractérisé en ce qu'**un matériau brut de cristal fourni précédemment à l'intérieur du cycle dans les matériaux bruts de cristal consiste en au moins un élément sélectionné dans le groupe constitué par Ga, Al, In, B, Zn et Cd tandis qu'un matériau brut de cristal fourni plus tard à l'intérieur du cycle consiste en au moins un élément sélectionné dans le groupe constitué par N, As, P, S, Se et Te.

7. Procédé de dopage pour semi-conducteur selon l'une quelconque des revendications 1 à 6, **caractérisé en ce que** les différents types de matériaux bruts d'impuretés pour dopage consistent en un matériau brut d'impuretés du type p et en un matériau brut d'impuretés du type n.

8. Procédé de dopage pour semi-conducteur selon l'une quelconque des revendications 1 à 7, **caractérisé**
**en ce que** les différents types de matériaux bruts d'impuretés pour dopage se composent de (Cp)₂Mg comme premier matériau brut d'impuretés, et de TESi comme second matériau brut d'impuretés,
**en ce que** les types de matériaux bruts de cristal se composent de TMGa comme premier matériau brut de cristal, et de NH₃ comme second matériau brut de cristal ;
**en ce que** le cycle comprend les étapes qui consistent :
(a) à fournir du TMGa et du (Cp)₂Mg à un premier moment,
(b) à terminer la fourniture de TMGa et de (Cp)₂Mg à un deuxième moment, où la fourniture de TMGa et de (Cp)₂Mg pour une période prédéterminée a été achevée ;
(c) à fournir du TESi soit immédiatement après, soit après le deuxième moment où la fourniture de TMGa et de (Cp)₂Mg a été terminée,
(d) à terminer la fourniture de TESi à un troisième moment, où la fourniture de TESi pour une période prédéterminée a été achevé ;
(e) à fournir du NH₃ soit immédiatement après, soit après le troisième moment où la fourniture de TESi est terminée,
(f) à terminer la fourniture de NH₃ à un quatrième moment, où la fourniture de NH₃ pour une période prédéterminée a été achevée ;
(g) à démarrer une durée de purge prédéterminée après la fourniture de NH₃ au quatrième moment où la fourniture de NH₃ a été achevée,
(h) à terminer la durée de purge prédéterminée, à un cinquième moment ;
**en ce que** ce cycle est répété un nombre de fois souhaité.

9. Matériau semi-conducteur (100-104 ; 200-204) comprenant une couche de cristal (102 ; 202), **caractérisé en ce que** la couche de cristal (102 ; 202) a différents types d'impuretés pour dopage (C-D ; Mg-S) qui sont disposés tout près les uns des autres dans la couche de cristal (10 ; 202) suivant un rapport prédéterminé.

10. Matériau semi-conducteur selon la revendication 9, **caractérisé en ce que** la couche de cristal se compose de Ga et comprend Mg et Si comme types d'impuretés pour dopage différents, qui sont disposés tout près les uns des autres dans la couche de cristal composée de Ga, suivant un rapport prédéterminé.
